# EUROPEAN PATENT APPLICATION

(11) **EP 4 712 751 A1**
(43) Date of publication of application: **18.03.2026**
(21) Application number: 25200348.8
(22) Date of filing: 04.09.2025
(51) Int. Cl.: H10N 69/00

(54) **QUBIT DEVICE AND METHOD OF MANUFACTURING QUBIT DEVICE**

(30) Priority: 10.09.2024 JP 2024156870
(71) Applicant: Fujitsu Limited, Kawasaki-shi, Kanagawa 211-8588 (JP)
(72) Inventor: KAWANO, Hiroyasu, Kawasaki-shi 211-8588 (JP); FUKUMORI, Taiga, Kawasaki-shi 211-8588 (JP); SHIMANOUCHI, Takeaki, Kawasaki-shi 211-8588 (JP)
(74) Representative: Haseltine Lake Kempner LLP

(57) **Abstract**

A qubit device (100) includes a first qubit substrate (10a) having a first qubit (30a) formed on a first surface (12a), a second qubit substrate (10b) having a second qubit (30b) formed on a second surface (12b), a connection substrate (40) disposed to face the first surface and the second surface, and a spacer portion (50) provided to be located at least between the connection substrate and the first qubit substrate, wherein the first surface and the second surface are located in a same plane, and the spacer portion is provided to be in contact with a third surface (15a) that is provided in a peripheral portion of the first qubit substrate and is lower than the first surface.

## Description

### FIELD

A certain aspect of embodiments described herein relates to a qubit device and a method of manufacturing a qubit device.

### BACKGROUND

In quantum computers, it is desired to increase the number of qubits for an increase in the amount of calculation. For example, it is known to form a plurality of qubits on a qubit substrate as disclosed in, for example, Japanese Patent Application Publication Nos. 2022-172189 and 2023-029561 (Patent Documents 1 and 2). It is known that qubits formed on a plurality of qubit substrates, respectively, are connected to each other via a connection substrate provided on the qubit substrates as disclosed in, for example, International Publication No. 2023/188391 (Patent Document 3). In addition, in order to suppress the characteristic deterioration, a method of preventing or reducing penetration of electromagnetic waves from the outside is known as disclosed in, for example, Patent Documents 1 to 3 and U.S. Patent Application Publication Nos. 2019/0042968 and 2017/0236787 (Patent Documents 4 and 5).

### SUMMARY

In a qubit device including a plurality of qubit substrates provided with qubits and a connection substrate disposed to face the qubit substrates, it is desired to prevent or reduce penetration of electromagnetic waves between the qubit substrates.

In one aspect, it is desirable to prevent or reduce penetration of electromagnetic waves between qubit substrates.

According to an aspect of the embodiments, there is provided a qubit device including: a first qubit substrate having a first qubit formed on a first surface; a second qubit substrate having a second qubit formed on a second surface; a connection substrate disposed to face the first surface and the second surface; and a spacer portion provided to be located at least between the connection substrate and the first qubit substrate, wherein the first surface and the second surface are located in a same plane, and wherein the spacer portion is provided to be in contact with a third surface that is provided in a peripheral portion of the first qubit substrate and is lower than the first surface.

According to another aspect of the embodiments, there is provided a method of manufacturing a qubit device, the method including: preparing a first qubit substrate having a first surface on which a first qubit is formed and a third surface lower than the first surface in a peripheral portion; preparing a second qubit substrate having a second surface on which a second qubit is formed; and disposing a connection substrate so as to face the first surface and the second surface located in a same plane by bringing a spacer portion into contact with the third surface.

### BRIEF DESCRIPTION OF DRAWINGS

The present invention is described, by way of example only, with reference to the following drawings, in which:
FIG. 1A is a plan view of a plurality of qubit substrates in a first embodiment, FIG. 1B is a plan view of a connection substrate and a spacer portion, and FIG. 1C is a cross-sectional view taken along line A-A in FIG. 1A and FIG. 1B.
FIG. 2 is a cross-sectional view of the qubit substrate in the first embodiment.
FIG. 3A is a plan view of a qubit in the first embodiment, FIG. 3B is a plan view of a Josephson device in the first embodiment, and FIG. 3C is a cross-sectional view taken along line A-A in FIG. 3B.
FIG. 4 is a cross-sectional view of a qubit device in the first embodiment.
FIG. 5A to FIG. 5C are cross-sectional views (No. 1) illustrating a method of manufacturing the qubit substrate in the first embodiment.
FIG. 6A to FIG. 6C are cross-sectional views (No. 2) illustrating the method of manufacturing the qubit substrate in the first embodiment.
FIG. 7A to FIG. 7C are cross-sectional views (No. 3) illustrating the method of manufacturing the qubit substrate in the first embodiment.
FIG. 8A to FIG. 8C are cross-sectional views (No. 1) illustrating a method of manufacturing the connection substrate in the first embodiment.
FIG. 9A to FIG. 9C are cross-sectional views (No. 2) illustrating the method of manufacturing the connection substrate in the first embodiment.
FIG. 10A and FIG. 10B are cross-sectional views illustrating a method of assembling and manufacturing the qubit substrate and the connection substrate in the first embodiment.
FIG. 11 is a cross-sectional view of a qubit device according to a comparative example.
FIG. 12A is a perspective view of a model used in a simulation, and FIG. 12B is a cross-sectional view taken along line A-A in FIG. 12A.
FIG. 13 is a diagram illustrating electromagnetic noise with respect to the insertion length of a wall portion in the simulation.
FIG. 14 is a cross-sectional view of a qubit device according to a first variation of the first embodiment;
FIG. 15 is a cross-sectional view of a qubit device according to a second variation of the first embodiment.
FIG. 16 is a cross-sectional view of a qubit device according to a second embodiment.
FIG. 17A and FIG. 17B are cross-sectional views illustrating a method of assembling and manufacturing the qubit substrate and the connection substrate in the second embodiment.
FIG. 18 is a cross-sectional view of a qubit device according to a variation of the second embodiment.

### DESCRIPTION OF EMBODIMENTS

Hereinafter, embodiments of the present disclosure will be described with reference to the drawings.

### First Embodiment

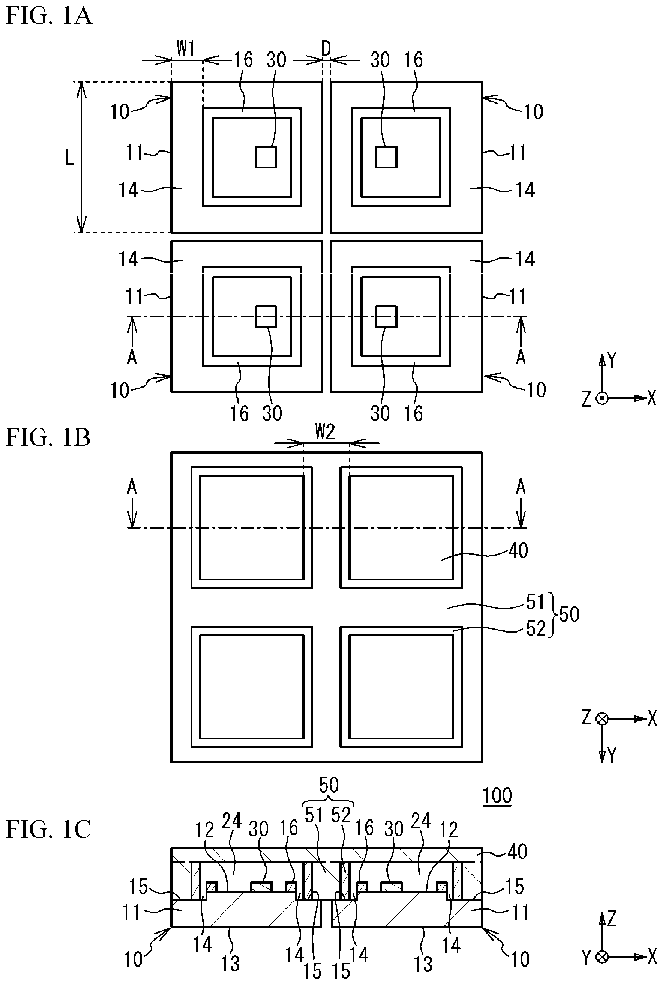

FIG. 1A is a plan view of a plurality of qubit substrates 10 in a first embodiment, FIG. 1B is a plan view of a connection substrate 40 and a spacer portion 50, and FIG. 1C is a cross-sectional view taken along line A-A in FIG. 1A and FIG. 1B. FIG. 1A to FIG. 1C illustrate an overview of a qubit device 100, and details of the qubit substrate 10, the connection substrate 40, and the spacer portion 50 are not illustrated. Directions parallel to the upper surface of the qubit substrate 10 and orthogonal to each other are defined as an X-axis direction and a Y-axis direction, and the normal direction of the upper surface is defined as a Z-axis direction. FIG. 1A is a plan view as viewed from the +Z direction, and FIG. 1B is a plan view as viewed from the -Z direction. The qubit device 100 is used in quantum computers, and is a device that operates in a superconducting state under extremely low temperature, such as several tens of millikelvin (mK).

As illustrated in FIG. 1A to FIG. 1C, the qubit device 100 according to the first embodiment includes a plurality of qubit substrates 10, the connection substrate 40, and the spacer portion 50. The qubit substrates 10 are arranged in a lattice form on the XY plane. The length L of one side of the qubit substrate 10 is, for example, 10 mm to 30 mm. The distance D between the qubit substrates 10 is, for example, 0.5 mm to 1.5 mm. The connection substrate 40 is mounted on the qubit substrates 10 with the spacer portion 50 interposed therebetween. The width W2 of the spacer portion 50 is, for example, 2 mm to 3 mm. The qubit substrates 10 have, for example, the same configuration. The number of the qubit substrates 10 is not limited to four, and may be any number as long as the number is two or more.

The qubit substrate 10 includes a base material 11 having an upper surface 12 and a lower surface 13, and a qubit 30 and a conductive portion 16 provided on the upper surface 12. For clarity, only one qubit 30 is illustrated, but a plurality of qubits 30 may be provided on the upper surface 12. The conductive portion 16 is provided in a frame shape so as to surround the qubit 30 in a plan view as viewed from the +Z direction. The conductive portion 16 is connected to, for example, the ground, but may be a floating conductor. When electromagnetic waves generated by the operation of the qubit 30 propagate to the adjacent qubit substrate 10, deterioration of quantum characteristics such as a decrease in coherence time may occur. The conductive portion 16 is provided to inhibit electromagnetic waves generated by the operation of the qubit 30 from propagating to another qubit substrate 10.

The base material 11 has a recess 14 in a peripheral portion outside the conductive portion 16. The recess 14 is provided in a frame shape so as to surround the conductive portion 16. A bottom surface 15 of the recess 14 is lower than the upper surface 12. The width W1 of the recess 14 is, for example, 0.5 mm to 1 mm. In FIG. 1A to FIG. 1C, the width of the recess 14 is enlarged for clarity.

The spacer portion 50 includes a first portion 51 formed of an insulating material that is the same as the base material of the connection substrate 40, and second portions 52 formed of a conductive material, and is formed integrally with the connection substrate 40 in the first portion 51. The spacer portion 50 is in contact with the bottom surface 15 of the recess 14. The spacer portion 50 is not bonded to the bottom surface 15. Since the spacer portion 50 is not bonded to the bottom surface 15, for example, the qubit substrate 10 in which an operation failure or the like occurs can be easily replaced. The connection substrate 40 is disposed to face the upper surfaces 12 of the qubit substrates 10 by the spacer portion 50. The upper surfaces 12 of the qubit substrates 10 are located in the same plane. An air gap 24 is formed between the connection substrate 40 and the upper surface 12 of the qubit substrate 10.

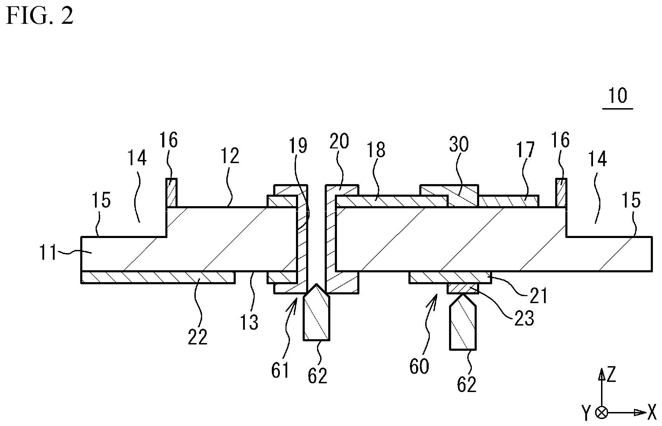

FIG. 2 is a cross-sectional view of the qubit substrate 10 in the first embodiment. As illustrated in FIG. 2, the qubit substrate 10 includes the base material 11, and the qubit 30, the conductive portion 16, a pad 17, and a superconducting film 18 that are formed on the upper surface 12 of the base material 11. The base material 11 is formed of, for example, an inorganic material having an insulating property, and is formed of, for example, silicon. The pad 17 and the superconducting film 18 are formed of a superconducting material that exhibits superconductivity at a temperature equal to or lower than a predetermined temperature (for example, 10 K or lower), and are formed of, for example, niobium or titanium nitride. The pad 17 and the superconducting film 18 may be formed of the same superconducting material or different superconducting materials. The pad 17 and the superconducting film 18 have thicknesses of, for example, about 100 nm. The conductive portion 16 is preferably formed of a superconducting material, and is formed of, for example, aluminum. The conductive portion 16 is a protruding conductive film, and has a thickness equal to or larger than the thicknesses of the pad 17 and the superconducting film 18. The conductive portion 16 has a thickness of, for example, 100 nm to 300 nm. The pad 17 is connected to the qubit 30. The pad 17 has a rectangular planar shape with a side length of about 200 µm, for example.

The base material 11 has a through hole 19 penetrating through the base material 11 from the upper surface 12 to the lower surface 13, and the recess 14 provided in the peripheral portion outside the conductive portion 16. The through hole 19 has a circular or elliptical planar shape in a plan view as viewed from the Z-axis direction, and has a diameter of, for example, about 150 µm. A via wiring 20 electrically connecting the upper surface 12 and the lower surface 13 is provided in the through hole 19. The via wiring 20 extends from the upper surface 12 to the lower surface 13 via the side wall of the through hole 19. The via wiring 20 is preferably formed of a superconducting material, and is formed of, for example, aluminum. The via wiring 20 has a thickness of, for example, about 300 nm. The qubit 30 is connected to the via wiring 20 through the superconducting film 18. The conductive portion 16 is provided in a frame shape so as to surround the qubit 30, the pad 17, the superconducting film 18, and the via wiring 20.

Superconducting films 21 and 22 are provided on the lower surface 13 of the base material 11. A superconducting film 23 is provided on the superconducting film 21. The superconducting films 21 and 23 overlap the qubit 30 in a plan view as viewed from the Z-axis direction. The superconducting films 21 and 22 are formed of, for example, niobium or titanium nitride, and have a thickness of, for example, about 100 nm. The superconducting film 23 is formed of, for example, aluminum, and has a thickness of, for example, about 300 nm. The superconducting films 21 and 23 are used as a control port 60. The control port 60 is used to control the qubit 30 from the outside. The via wiring 20 on the lower surface 13 is used as a read port 61. The read port 61 is used to extract a bit signal indicating the state of the qubit 30 to the outside. Probes 62 are pressed against the control port 60 and the read port 61, respectively.

The base material 11 is not limited to a silicon substrate, and may be formed of an insulating material such as a glass substrate, a quartz substrate, a sapphire substrate, an alumina substrate, or a silicon carbide substrate. The conductive portion 16, the pad 17, the superconducting film 18, the via wiring 20, and the superconducting films 21 to 23 may be formed to contain at least one of the following substances: niobium, vanadium, tantalum, aluminum, titanium, zinc, gallium, zirconium, molybdenum, technetium, cadmium, indium, tin, hafnium, and titanium nitride.

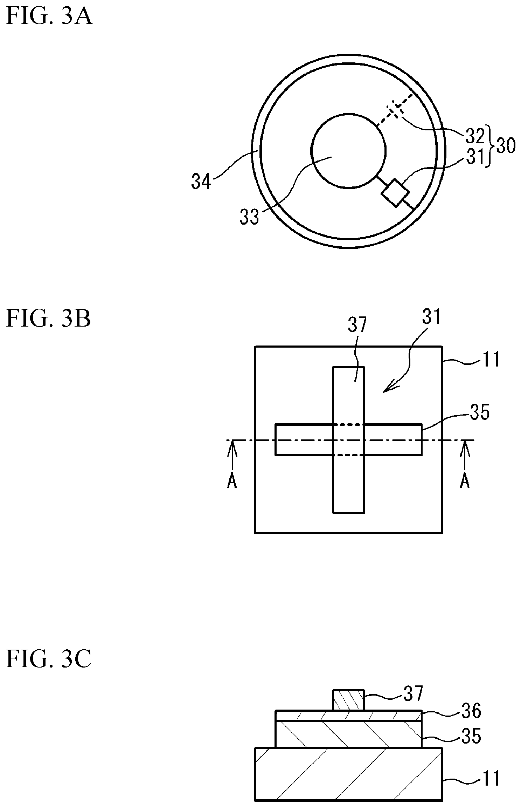

FIG. 3A is a plan view of the qubit 30 in the first embodiment. As illustrated in FIG. 3A, the qubit 30 includes a Josephson device 31 connected between a central electrode 33 and a peripheral electrode 34, and a capacitor 32 formed by the central electrode 33 and the peripheral electrode 34 facing each other. That is, the qubit 30 includes a transmon qubit circuit in which the Josephson device 31 and the capacitor 32 are connected in parallel. The qubit 30 is an element that forms a coherent two-level system using superconductivity. The central electrode 33 and the peripheral electrode 34 are formed of, for example, the superconducting film 18.

FIG. 3B is a plan view of the Josephson device 31 in the first embodiment, and FIG. 3C is a cross-sectional view taken along line A-A in FIG. 3B. In FIG. 3B, the insulating film 36 is not illustrated. As illustrated in FIG. 3B and FIG. 3C, the Josephson device 31 includes a lower electrode 35 and an upper electrode 37, each of which is made of a superconducting material, and an insulating film 36 made of an insulating material and sandwiched between the lower electrode 35 and the upper electrode 37. The lower electrode 35 and the upper electrode 37 extend so as to intersect each other. The lower electrode 35 and the upper electrode 37 are formed of, for example, aluminum, and the insulating film 36 is formed of, for example, aluminum oxide.

The qubit 30 is not limited to the transmon qubit circuit including the Josephson device 31, and may be other circuits.

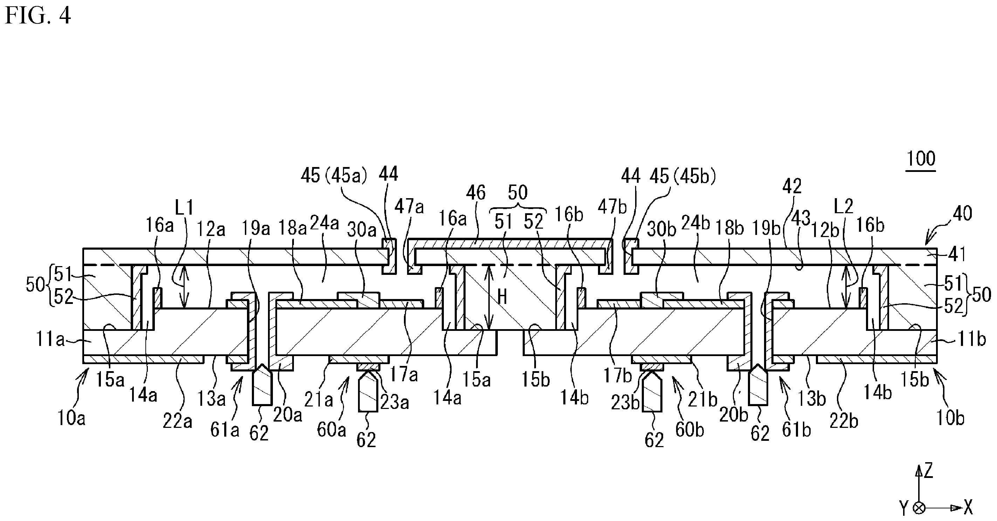

FIG. 4 is a cross-sectional view of the qubit device 100 according to the first embodiment. FIG. 4 illustrates two qubit substrates 10 arranged side by side in the X-axis direction. As illustrated in FIG. 4, one of the two qubit substrates 10 is referred to as a qubit substrate 10a, and the other is referred to as a qubit substrate 10b. The base material constituting the qubit substrate 10a is referred to as a base material 11a. The recess provided in the peripheral portion of an upper surface 12a of the base material 11a is referred to as a recess 14a, and the bottom surface thereof is referred to as a bottom surface 15a. The components provided on the upper surface 12a are a conductive portion 16a, a pad 17a, a superconducting film 18a, and a qubit 30a. A through hole penetrating through the base material 11a from the upper surface 12a to a lower surface 13a is referred to as a through hole 19a, and a via wiring provided in the through hole 19a is referred to as a via wiring 20a. The components provided on the lower surface 13a of the base material 11a are a superconducting film 21a, a superconducting film 22a, and a superconducting film 23a. The superconducting films 21a and 23a are used as a control port 60a for controlling the qubit 30a from the outside. The via wiring 20a on the lower surface 13a is used as a read port 61a for extracting bit signals indicating the state of the qubit 30a to the outside.

Similarly, the base material constituting the qubit substrate 10b is referred to as a base material 11b. The recess provided in the peripheral portion of an upper surface 12b of the base material 11b is referred to as a recess 14b, and the bottom surface thereof is referred to as a bottom surface 15b. The components provided on the upper surface 12b are a conductive portion 16b, a pad 17b, a superconducting film 18b, and a qubit 30b. A through hole penetrating through the base material 11b from the upper surface 12b to a lower surface 13b is referred to as a through hole 19b, and a via wiring provided in the through hole 19b is referred to as a via wiring 20b. The components provided on the lower surface 13b of the base material 11b are a superconducting film 21b, a superconducting film 22b, and a superconducting film 23b. The superconducting film 21b and 23b are used as a control port 60b for controlling the qubit 30b from the outside. The via wiring 20b on the lower surface 13b is used as a read port 61b for extracting bit signals indicating the state of the qubit 30b to the outside.

The connection substrate 40 includes a base material 41, a plurality of through holes 44 penetrating through the base material 41 from an upper surface 42 to a lower surface 43, via wirings 45 provided in the through holes 44, respectively, and a wiring line 46 connecting the via wirings 45. The base material 41 is formed of, for example, an inorganic material having an insulating property, and is formed of, for example, silicon. The via wiring 45 extends from the upper surface 42 to the lower surface 43 via the side wall of the through hole 44. The through hole 44 has a circular or elliptical planar shape in a plan view as viewed from the Z-axis direction, and has a diameter of, for example, about 100 µm. The connection substrate 40 is disposed to face the respective upper surfaces 12a and 12b of the qubit substrates 10a and 10b, by the spacer portion 50. The upper surfaces 12a and 12b are located in the same plane. The respective distances L1 and L2 between the spacer portion 50 and the upper surfaces 12a and 12b are, for example, 10 µm to 20 µm. The distance L1 and the distance L2 are substantially the same. The height H of the spacer portion 50 is, for example, 50 µm to 200 µm.

The spacer portion 50 includes the first portion 51 and the second portions 52. The first portion 51 is formed of the same insulating material as the base material 41 and is provided integrally with the base material 41. For example, the first portion 51 and the base material 41 are formed of silicon. The second portions 52 are provided on the side surfaces of the first portion 51. The second portion 52 is formed of a material having conductivity. The second portion 52 is preferably formed of a superconducting material, and is formed of, for example, aluminum. The thickness of the second portion 52 is, for example, 10 nm to 100 nm, or may be 50 nm to 100 nm. The second portion 52 is connected to, for example, the ground, but may be a floating conductor. The via wiring 45 and the wiring line 46 are preferably formed of a superconducting material, and are formed of, for example, aluminum.

The spacer portion 50 is in contact with the bottom surface 15a of the recess 14a formed in the qubit substrate 10a and the bottom surface 15b of the recess 14b formed in the qubit substrate 10b. Since the first portion 51 and the second portions 52 of the spacer portion 50 are in contact with the bottom surfaces 15a and 15b, no other film such as a metallic film is provided between the first portion 51 and each of the bottom surfaces 15a and 15b.

One via wiring 45a of the via wirings 45 faces the pad 17a of the qubit substrate 10a with an air gap 24a interposed therebetween in a plan view as viewed from the Z-axis direction. Another via wiring 45b faces the pad 17b of the qubit substrate 10b with an air gap 24b interposed therebetween in a plan view as viewed from the Z-axis direction. As a result, the via wiring 45a and the pad 17a are capacitively coupled, and the via wiring 45b and the pad 17b are capacitively coupled. In this manner, the via wirings 45a and 45b on the lower surface 43 function as pads 47a and 47b coupled to the pads 17a and 17b. The pads 47a and 47b have thicknesses of, for example, about 150 µm. The via wiring 45a capacitively coupled to the pad 17a and the via wiring 45b capacitively coupled to the pad 17b are connected through the wiring line 46 provided on the upper surface 42 of the base material 41. Therefore, the qubit 30a and the qubit 30b are connected to each other through the connection substrate 40. The outer edges of the pads 47a and 47b may be located further in than the outer edges of the pads 17a and 17b.

The upper surface 12a of the qubit substrate 10a and the upper surface 12b of the qubit substrate 10b are located in the same plane. Therefore, by controlling the height of the spacer portion 50, the distance between the pad 17a and the pad 47a and the distance between the pad 17b and the pad 47b can be set to appropriate distances. That is, the electrostatic capacitance between the pad 17a and the pad 47a and the electrostatic capacitance between the pad 17b and the pad 47b can be set to appropriate values. Therefore, the qubit 30a and the qubit 30b can be stably connected to each other. To set the distance between the pad 17a and the pad 47a and the distance between the pad 17b and the pad 47b to appropriate distances, the conductive portions 16a and 16b are separated from the connection substrate 40 without being in contact with the connection substrate 40.

The electromagnetic waves generated by the operation of the qubit 30a are inhibited from propagating to the outside by the conductive portion 16a and the second portions 52, which are made of the conductive material, of the spacer portion 50. Similarly, the electromagnetic waves generated by the operation of the qubit 30b are inhibited from propagating to the outside by the conductive portion 16b and the second portions 52, which are made of the conductive material, of the spacer portion 50. Therefore, the degradation of the quantum characteristics of the qubits 30a and 30b is prevented or reduced.

The base material 41 of the connection substrate 40 and the first portion 51 of the spacer portion 50 are not limited to being formed of silicon, and may be formed of a material having an insulating property such as glass, quartz, sapphire, silicon, alumina, or silicon carbide. The via wiring 45, the wiring line 46, and the second portion 52 of the spacer portion 50 are not limited to being formed of aluminum, and may be formed to include at least one of the following substances: niobium, vanadium, tantalum, aluminum, titanium, zinc, gallium, zirconium, molybdenum, technetium, cadmium, indium, tin, hafnium, and titanium nitride.

### Method of Manufacturing Qubit Substrate

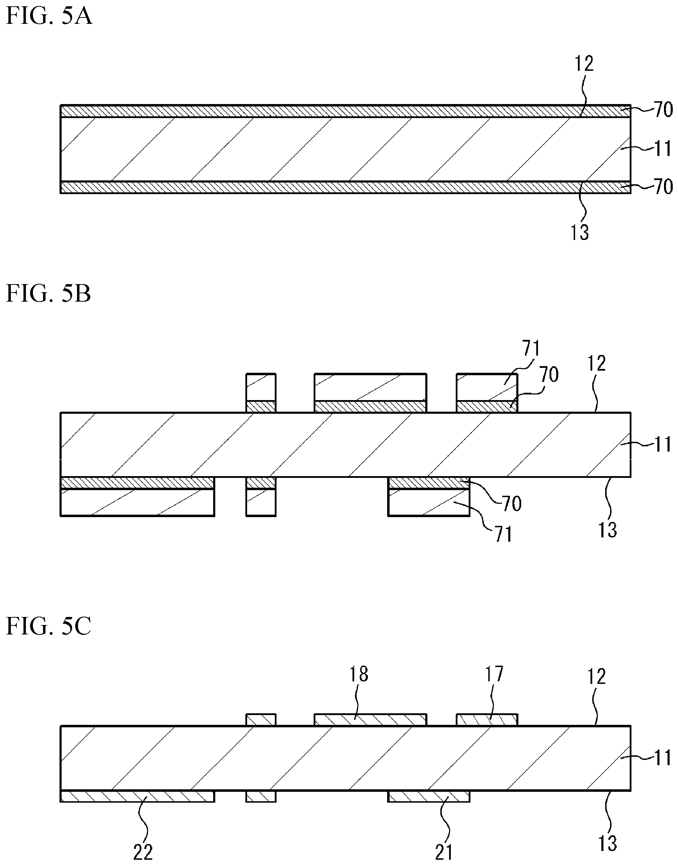

FIG. 5A to FIG. 7C are cross-sectional views illustrating a method of manufacturing the qubit substrate 10 in the first embodiment. As illustrated in FIG. 5A, the base material 11, which is, for example, a silicon substrate, is prepared. The thickness of the base material 11 is, for example, about 300 µm. Superconducting films 70 made of, for example, niobium or titanium nitride are formed on the upper surface 12 and the lower surface 13 of the base material 11, respectively. The superconducting film 70 is formed by, for example, sputtering, chemical vapor deposition (CVD), or ion plating. The thickness of the superconducting film 70 is, for example, about 100 nm.

As illustrated in FIG. 5B, a resist film 71 is formed on the superconducting film 70 on each of the upper surface 12 and the lower surface 13 of the base material 11 by photolithography. The superconducting film 70 is patterned by etching the superconducting film 70 using the resist film 71 as a mask. The etching of the superconducting film 70 is performed by, for example, dry etching.

As illustrated in FIG. 5C, the resist film 71 is removed. As a result, the pad 17 and the superconducting film 18 are formed on the upper surface 12 of the base material 11. The superconducting films 21 and 22 are formed on the lower surface 13.

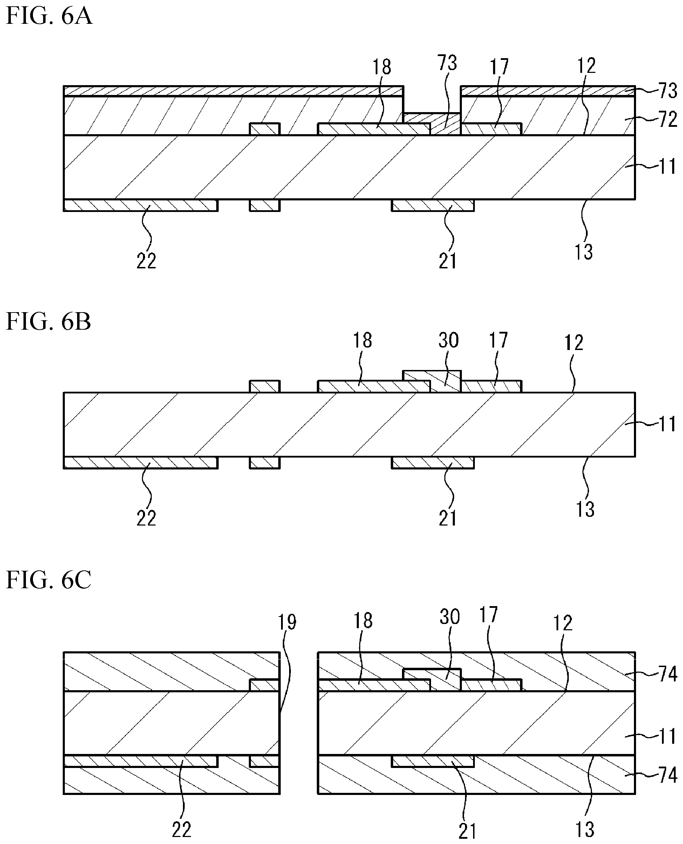

As illustrated in FIG. 6A, a resist film 72 is formed on the upper surface 12 of the base material 11 by photolithography. The resist film 72 is used as a mask to form the lower electrode 35, the insulating film 36 on the lower electrode 35, and the upper electrode 37, thereby forming a multilayer film 73 of these films (also see FIG. 3B and FIG. 3C). The lower electrode 35 and the upper electrode 37 are formed by, for example, oblique vacuum evaporation. The insulating film 36 is formed by, for example, oxidizing the surface of the lower electrode 35.

As illustrated in FIG. 6B, the resist film 72 and the multilayer film 73 formed on the resist film 72 are removed. As a result, the qubit 30 is formed on the upper surface 12 of the base material 11. The qubit 30 is formed to be connected to the pad 17 and the superconducting film 18.

As illustrated in FIG. 6C, resist films 74 are formed on the upper surface 12 and the lower surface 13 of the base material 11, respectively, by photolithography. The base material 11 is etched using the resist film 74 as a mask, thereby forming the through hole 19 penetrating through the base material 11 from the upper surface 12 to the lower surface 13. The through holes 19 are formed by reactive ion etching such as deep reactive ion etching (Deep-RIE) using the Bosch process, for example.

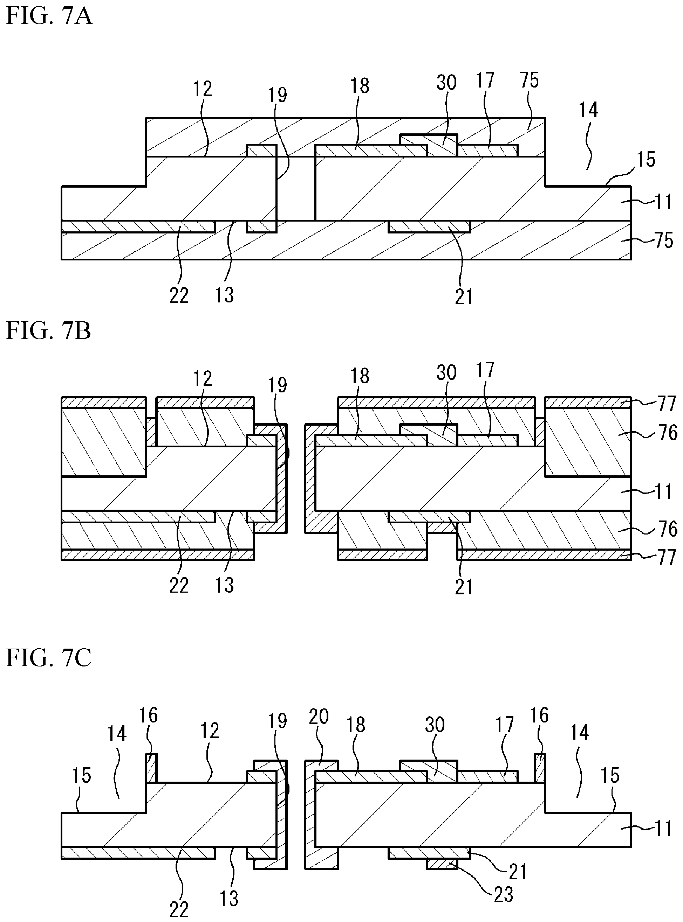

As illustrated in FIG. 7A, the resist film 74 is removed. Thereafter, resist films 75 are formed on the upper surface 12 and the lower surface 13 of the base material 11, respectively, by photolithography. The base material 11 is etched using the resist film 75 as a mask, thereby forming the recess 14 in the peripheral portion of the base material 11. The bottom surface 15 of the recess 14 is lower than the upper surface 12. The depth of the recess 14 is, for example, 40 µm to 180 µm. The recess 14 is formed by, for example, reactive ion etching.

As illustrated in FIG. 7B, the resist film 75 is removed. Thereafter, resist films 76 are formed on the upper surface 12 and the lower surface 13 of the base material 11, respectively, by photolithography. A superconducting film 77 is formed by, for example, vacuum evaporation using the resist film 76 as a mask. The thickness of the superconducting film 77 is, for example, about 300 nm.

As illustrated in FIG. 7C, the resist film 76 and the superconducting film 77 formed on the resist film 76 are removed. This forms the conductive portion 16 on the upper surface 12 of the base material 11. The superconducting film 23 is formed on the superconducting film 21 on the lower surface 13 of the base material 11. Formed is the via wiring 20 extending from the upper surface 12 of the base material 11 to the lower surface 13 via the side wall of the through hole 19. Through the above steps, the qubit substrate 10 is formed.

### Method for Manufacturing Connection Substrate

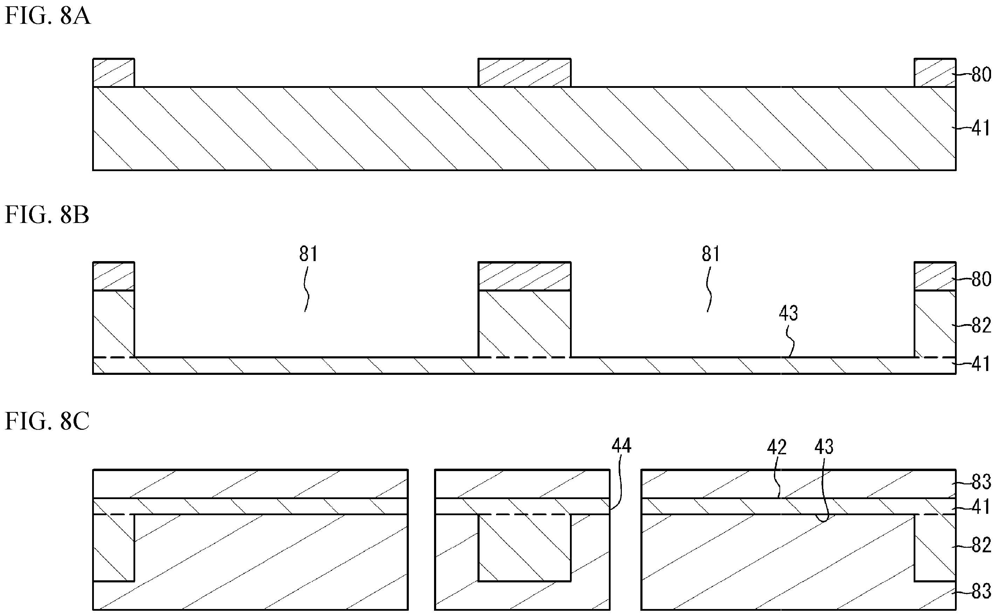

FIG. 8A to FIG. 9C are cross-sectional views illustrating a method of manufacturing the connection substrate 40 in the first embodiment. As illustrated in FIG. 8A, the base material 41, which is, for example, a silicon substrate, is prepared. The thickness of the base material 41 is, for example, about 300 µm. A resist film 80 is formed on a first surface of the base material 41 by photolithography.

As illustrated in FIG. 8B, the base material 41 is etched using the resist film 80 as a mask to form recess portions 81 in the base material 41. As a result, a protruding portion 82 is formed around the recess portions 81. When the bottom surface of the recess portion 81 is the lower surface 43 of the base material 41 (the surface facing upward in FIG. 8B), the protruding portion 82 is formed on the lower surface 43. The depth of the recess portion 81 is, for example, 50 µm to 200 µm. The recess portion 81 is formed by reactive ion etching such as Deep-RIE using the Bosch process, for example.

As illustrated in FIG. 8C, after the resist film 80 is removed, the base material 41 is turned upside down, and resist films 83 are formed on the upper surface 42 and the lower surface 43 of the base material 41 by photolithography. The base material 41 is etched using the resist film 83 as a mask to form the through holes 44 penetrating through the base material 41 from the upper surface 42 to the lower surface 43. The through holes 44 are formed by, for example, reactive ion etching.

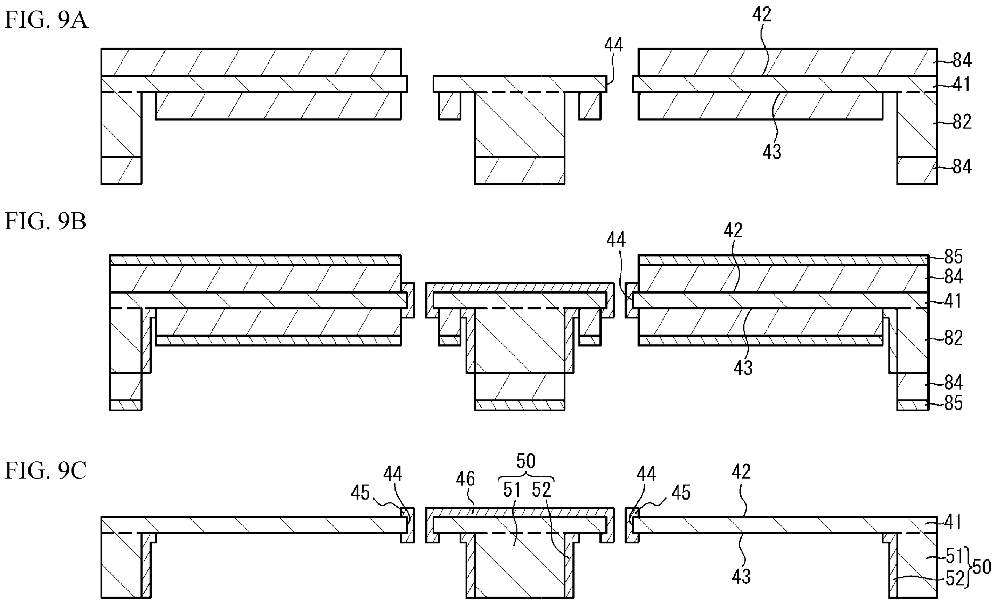

As illustrated in FIG. 9A, the resist film 83 is removed. Thereafter, resist films 84 are formed on the upper surface 42 and the lower surface 43 of the base material 41, respectively, by photolithography.

As illustrated in FIG. 9B, superconducting films 85 are formed by, for example, vacuum evaporation using the resist film 84 as a mask. The superconducting film 85 is, for example, an aluminum film. The thickness of the superconducting film 85 is, for example, about 300 nm.

As illustrated in FIG. 9C, the resist film 84 and the superconducting film 85 formed on the resist film 84 are removed. Thereby, the spacer portion 50 including the first portion 51 made of the protruding portion 82 and the second portions 52 provided on the side surfaces of the first portion 51 and made of the superconducting film 85 is formed. Formed is the via wiring 45 extending from the upper surface 42 to the lower surface 43 in the through hole 44 of the base material 41. The wiring line 46 connected to the via wiring 45 is formed on the upper surface 42 of the base material 41. In this manner, the connection substrate 40 is formed.

### Method of Assembling and Manufacturing Qubit Substrate and Connection Substrate

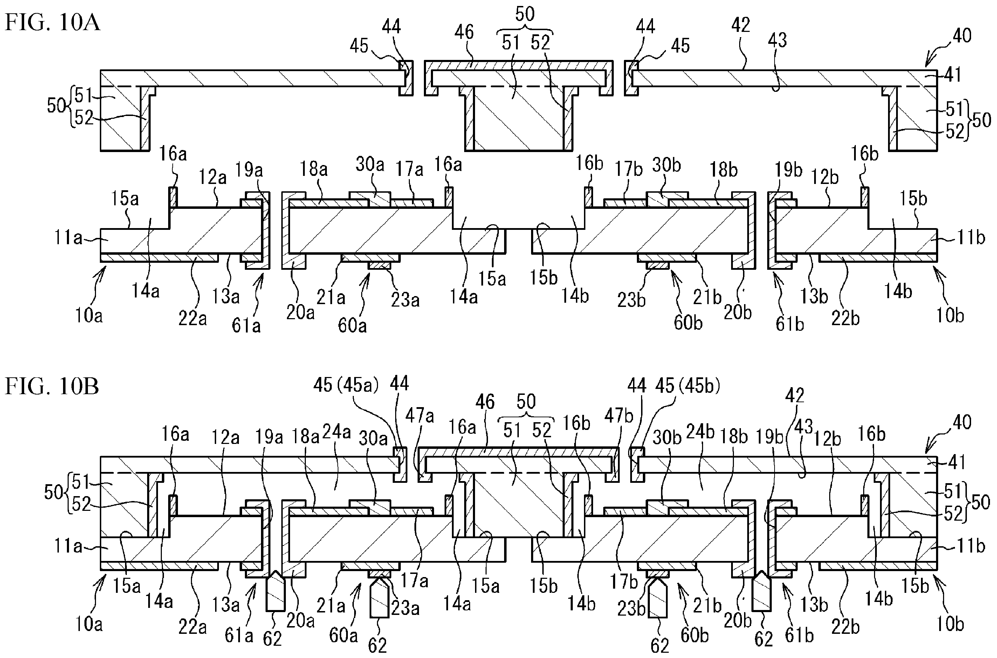

FIG. 10A and FIG. 10B are cross-sectional views illustrating a method of assembling and manufacturing the qubit substrate 10 and the connection substrate 40 according to the first embodiment. In FIG. 10A and FIG. 10B, the qubit substrate 10a and the qubit substrate 10b among the plurality of qubit substrates 10 are illustrated and described, but the same applies to other qubit substrates 10.

As illustrated in FIG. 10A, the qubit substrate 10a and the qubit substrate 10b are arranged so that the respective upper surfaces 12a and 12b of the qubit substrates 10a and 10b are located in the same plane. Thereafter, the upper surfaces 12a and 12b of the qubit substrates 10a and 10b are made to face the lower surface 43 of the connection substrate 40.

As illustrated in FIG. 10B, the spacer portion 50 provided on the connection substrate 40 is brought into contact with the bottom surfaces 15a and 15b of the recesses 14a and 14b provided on the qubit substrates 10a and 10b. As a result, the connection substrate 40 is mounted on the qubit substrates 10a and 10b. Thereafter, the probes 62 are pressed against the control ports 60a and 60b and the read ports 61a and 61b. This inhibits the qubit substrates 10a and 10b and the connection substrate 40 from moving relative to each other. Through the above processes, the assembly of the qubit substrate 10 and the connection substrate 40 is completed, and the qubit device 100 according to the first embodiment is formed.

### Comparative Example

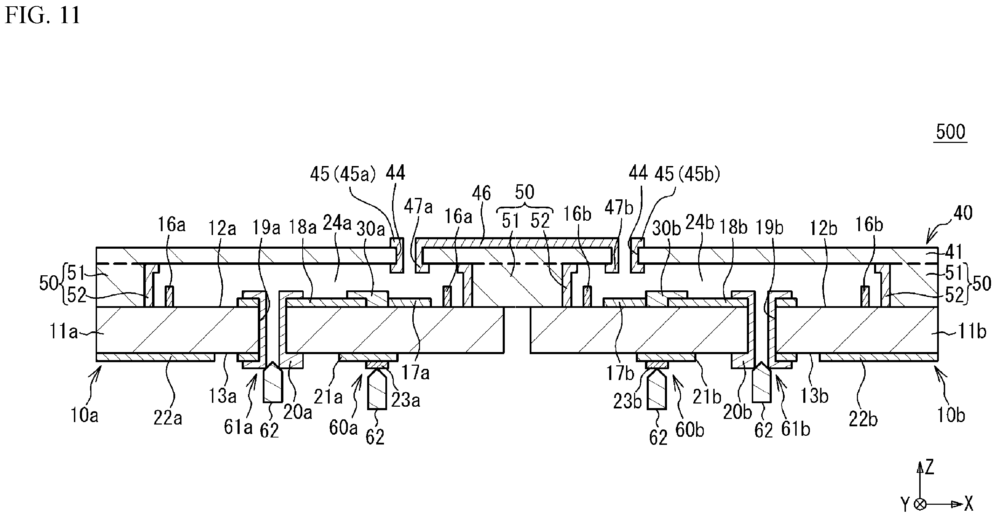

FIG. 11 is a cross-sectional view of a qubit device 500 according to a comparative example. As illustrated in FIG. 11, in the comparative example, no recess is formed in the peripheral portions of the base materials 11a and 11b. Therefore, the spacer portion 50 is in contact with the upper surfaces 12a and 12b of the base materials 11a and 11b. Other configurations are the same as those in FIG. 4 of the first embodiment, and thus the description thereof will be omitted.

In the comparative example, the conductive portions 16a and 16b are provided so as to surround the qubits 30a and 30b. The conductive portions 16a and 16b are separated from the connection substrate 40 without being in contact with the connection substrate 40 so that the distance between the pad 17a and the pad 47a and the distance between the pad 17b and the pad 47b are appropriate distances. Therefore, an air gap is formed between each of the conductive portions 16a and 16b and the connection substrate 40. Since the air gap is formed between each of the conductive portions 16a and 16b and the connection substrate 40, a part of the electromagnetic waves generated by the operation of the qubits 30a and 30b propagates beyond the conductive portions 16a and 16b.

The spacer portion 50 is provided outside the conductive portions 16a and 16b. The spacer portion 50 has the second portions 52 made of a conductive material on the side surfaces thereof. Therefore, the electromagnetic waves propagated beyond the conductive portions 16a and 16b are inhibited from propagating to the outside by the second portions 52 of the spacer portion 50. However, since the spacer portion 50 is only in contact with the upper surfaces 12a and 12b of the qubit substrates 10a and 10b and is not bonded thereto, a gap may be formed between the spacer portion 50 and each of the upper surfaces 12a and 12b. Therefore, the electromagnetic waves may propagate to the outside through the gap. Therefore, electromagnetic waves generated by the operation of one of the qubits 30a and 30b may propagate to the other qubit substrate, and the qubit characteristics may deteriorate.

### Simulation

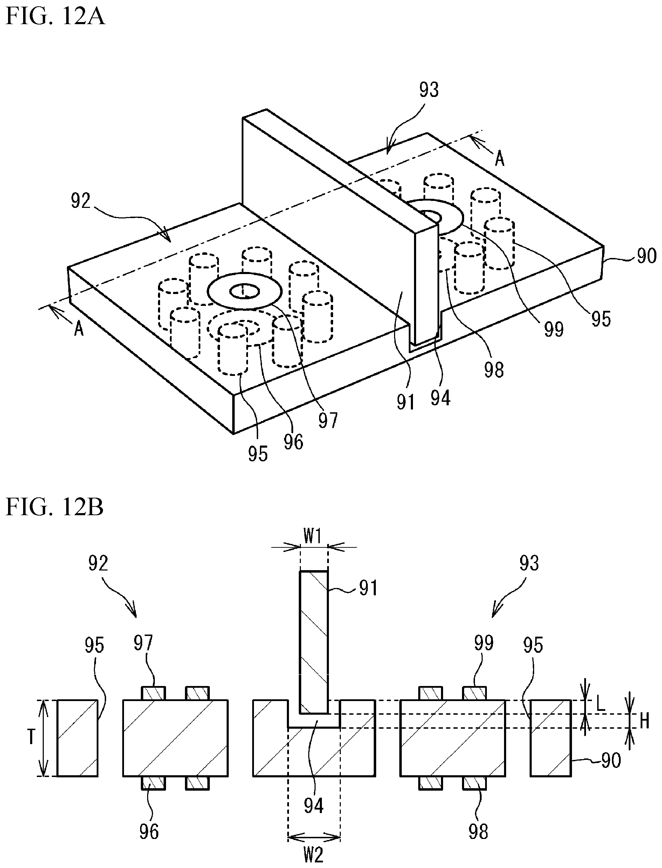

FIG. 12A is a perspective view of a model used in a simulation, and FIG. 12B is a cross-sectional view taken along line A-A in FIG. 12A. As illustrated in FIG. 12A and FIG. 12B, the model used in the simulation has a structure in which a recess 94 extending in one direction is provided in a central portion of a base material 90, and a wall portion 91 is inserted into the recess 94. One of two regions sandwiching the wall portion 91 in the base material 90 is defined as a region 92, and the other is defined as a region 93. In each of the regions 92 and 93, a plurality of through holes 95 penetrating through the base material 90 are provided. In the region 92, a ring portion 96 located further in than the plurality of through holes 95 is provided on the lower surface of the base material 90, and a ring portion 97 located further in than the plurality of through holes 95 is provided on the upper surface of the base material 90. Similarly, in the region 93, a ring portion 98 located further in than the plurality of through holes 95 is provided on the lower surface of the base material 90, and a ring portion 99 located further in than the plurality of through holes 95 is provided on the upper surface of the base material 90.

It was assumed that the ring portions 96 to 99 were formed of silicon. It was assumed that the base material 90 was formed of an insulator. It was assumed that an air gap was formed inside the through hole 95 and a superconductor film was formed on the side wall. It was assumed that the wall portion 91 was formed of a conductor. The thickness T of the base material 90 was set to 300 µm. The width W1 of the wall portion 91 was set to 200 µm. The width W2 of the recess 94 was set to 250 µm. The distance H between the wall portion 91 and the base material 90 was set to 30 µm. The length of the part of the wall portion 91 inserted into the recess 94 was defined as an insertion length L. When the insertion length L was varied and a high-frequency signal of 8 GHz was input to the ring portion 96, electromagnetic waves that propagated through the ring portion 97, the gap between the wall portion 91 and the base material 90, and the ring portion 99 and were output from the ring portion 98 were calculated as electromagnetic noise.

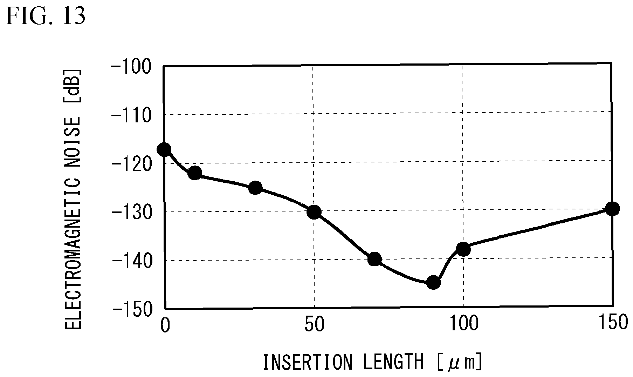

FIG. 13 is a diagram illustrating electromagnetic noise with respect to the insertion length L of the wall portion 91 in the simulation. In FIG. 13, black circles represent the results of the actual simulation. The solid line is a line connecting the black circles. As illustrated in FIG. 13, the electromagnetic noise decreased as the insertion length L increased until the insertion length L reached a certain value. Specifically, the electromagnetic noise was -117 dB when the insertion length L was 0 µm (the recess 94 was not formed), whereas the electromagnetic noise was -122 dB when the insertion length L was 10 µm and -125 dB when the insertion length L was 30 µm. The electromagnetic noise was -130 dB when the insertion length L was 50 µm, - 140 dB when the insertion length L was 70 µm, -145 dB when the insertion length L was 90 µm, -138 dB when the insertion length L was 100 µm, and -130 dB when the insertion length L was 150 µm.

Therefore, when a high-frequency signal around 8 GHz is used, the insertion length L is preferably 10 µm or greater and 150 µm or less to reduce electromagnetic noise. The insertion length L is more preferably 30 µm or greater and 150 µm or less, still more preferably 50 µm or greater and 150 µm or less, and yet still more preferably 70 µm or greater and 100 µm or less. Since the depth of the recess 94 is represented by (the insertion length L + the distance H), the depth of the recess 94 is preferably 40 µm or greater and 180 µm or less, and more preferably 60 µm or greater and 180 µm or less. The depth of the recess 94 is further preferably 80 µm or greater and 180 µm or less, and still further preferably 100 µm or greater and 130 µm or less.

The simulation results reveals that the propagation of the electromagnetic wave through the gap between the wall portion 91 and the base material 90 is suppressed by providing the recess 94 in the base material 90 and inserting the wall portion 91 into the recess 94. The reason why the propagation of the electromagnetic wave was suppressed is considered to be that the shortest distance of the path through which the electromagnetic wave propagates between the ring portion 97 and the ring portion 99 was increased. In other words, it is considered that the creepage distance between the ring portion 97 and the ring portion 99 was increased. The reason why the electromagnetic noise increased when the insertion length L was greater than 90 µm is not clear.

As in the comparative example illustrated in FIG. 11, when the spacer portion 50 is in contact with the upper surfaces 12a and 12b of the qubit substrates 10a and 10b, the shortest length of the propagation path of the electromagnetic waves between the qubit substrate 10a and the qubit substrate 10b is short. Therefore, electromagnetic waves generated by the operation of the qubit provided in one of the qubit substrates 10a and 10b may penetrate to the other qubit substrate to some extent, causing the qubit characteristics to deteriorate. In contrast, as in the first embodiment illustrated in FIG. 4, when the spacer portion 50 is in contact with the bottom surfaces 15a and 15b of the recesses 14a and 14b, the shortest length of the propagation path of the electromagnetic waves between the qubit substrate 10a and the qubit substrate 10b is longer. Therefore, the electromagnetic waves generated by the operation of the qubit provided in one of the qubit substrates 10a and 10b are inhibited from penetrating to the other qubit substrate, and the degradation of the qubit characteristics can be prevented or reduced.

### Variations

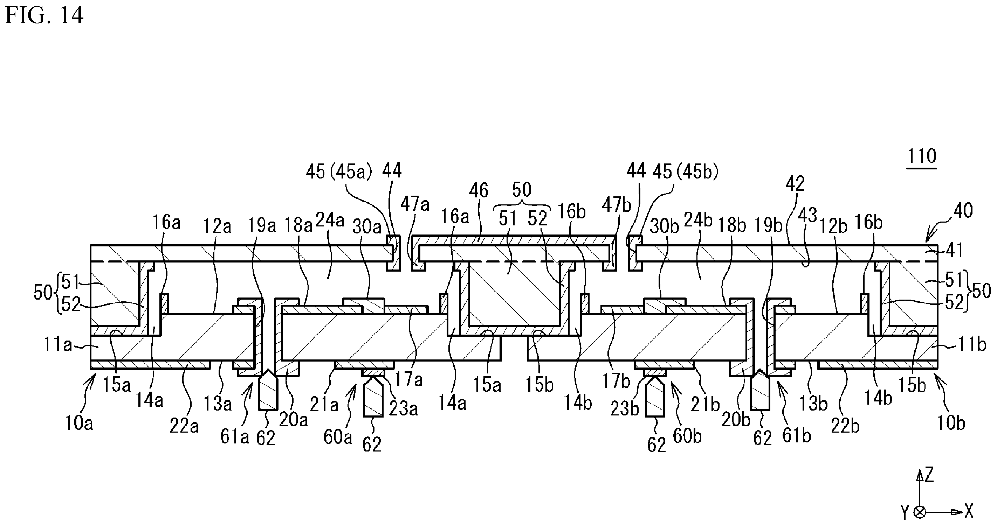

FIG. 14 is a cross-sectional view of a qubit device 110 according to a first variation of the first embodiment. As illustrated in FIG. 14, in the first variation of the first embodiment, the second portions 52 of the spacer portion 50 cover the side surfaces and the lower surfaces of the first portion 51. Therefore, the second portions 52 of the spacer portion 50 are in contact with the bottom surfaces 15a and 15b of the recesses 14a and 14b formed in the qubit substrates 10a and 10b. That is, the first portion 51 is not in contact with any of the bottom surfaces 15a and 15b. Other configurations are the same as those of the first embodiment, and thus the description thereof will be omitted.

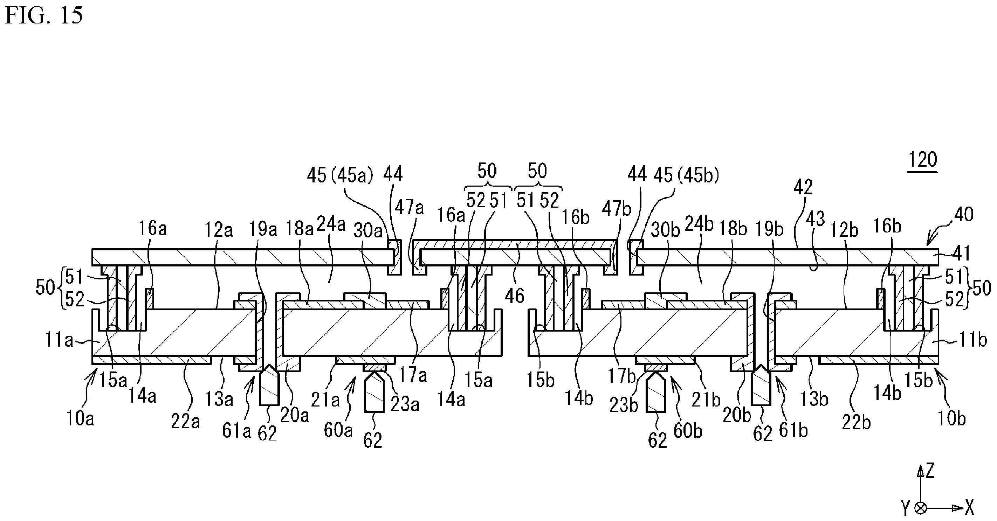

FIG. 15 is a cross-sectional view of a qubit device 120 according to a second variation of the first embodiment. As illustrated in FIG. 15, in the second variation of the first embodiment, the spacer portion 50 that is in contact with the bottom surface 15a of the recess 14a formed in the qubit substrate 10a and the spacer portion 50 that is in contact with the bottom surface 15b of the recess 14b formed in the qubit substrate 10b are separately provided. The recesses 14a and 14b may be provided inwardly away from the outer edges of the base materials 11a and 11b. Other configurations are the same as those of the first embodiment, and thus the description thereof will be omitted.

According to the first embodiment and the variations thereof, as illustrated in FIG. 4, FIG. 14, and FIG. 15, the upper surface 12a (first surface) of the qubit substrate 10a (first qubit substrate) and the upper surface 12b (second surface) of the qubit substrate 10b (second qubit substrate) are located in the same plane. The qubit 30a (first qubit) is formed on the upper surface 12a. The qubit 30b (second qubit) is formed on the upper surface 12b. The connection substrate 40 is disposed so as to face the upper surfaces 12a and 12b by the spacer portion 50. The spacer portion 50 is located at least between the connection substrate 40 and the qubit substrate 10a, and is provided so as to be in contact with the bottom surface 15a (third surface), which is lower than the upper surface 12a provided in the peripheral portion of the qubit substrate 10a, of the recess 14a. This lengthens the shortest distance of the propagation path of the electromagnetic waves between the qubit substrate 10a and the qubit substrate 10b. Therefore, it is possible to prevent or reduce penetration of electromagnetic waves between the qubit substrate 10a and the qubit substrate 10b, and to suppress deterioration of the qubit characteristics.

According to the first embodiment and the variations thereof, as illustrated in FIG. 10A, prepared is the qubit substrate 10a that has the qubit 30a formed on the upper surface 12a and has the recess 14a of which the bottom surface 15a is lower than the upper surface 12a in the peripheral portion. Prepared is the qubit substrate 10b that has the qubit 30b formed on the upper surface 12b. As illustrated in FIG. 10B, the connection substrate 40 is disposed so as to face the upper surfaces 12a and 12b that are located in the same plane by bringing the spacer portion 50 into contact with the bottom surface 15a of the recess 14b. This lengthens the shortest distance of the propagation path of the electromagnetic waves between the qubit substrate 10a and the qubit substrate 10b. Therefore, it is possible to prevent or reduce penetration of electromagnetic waves between the qubit substrate 10a and the qubit substrate 10b, and to prevent or reduce deterioration of the qubit characteristics.

In the first embodiment and the variations thereof, as illustrated in FIG. 4, FIG. 14, and FIG. 15, the qubit substrate 10a has the pad 17a (first pad) connected to the qubit 30a on the upper surface 12a. The qubit substrate 10b has the pad 17b (second pad) connected to the qubit 30b on the upper surface 12b. The connection substrate 40 has the pad 47a (third pad) facing the pad 17a, the pad 47b (fourth pad) facing the pad 17b, and the wiring line 46 connecting the pad 47a and the pad 47b. This allows the qubit 30a and the qubit 30b to be connected to each other via the connection substrate 40.

In the first embodiment and the variations thereof, the spacer portion 50 includes the first portion 51 made of an insulating material and the second portion 52 made of a conductive material and located on the side surface of the first portion 51. This inhibits electromagnetic waves generated by the operation of the qubits 30a and 30b from leaking to the outside through the spacer portion 50. Therefore, it is possible to inhibit or reduce penetration of electromagnetic waves between the qubit substrate 10a and the qubit substrate 10b. The second portion 52 is preferably formed of a superconducting material. This reduces the electrical resistance of the second portion 52 during operation of the qubit device at extremely low temperatures, thereby suppressing heat generation in the second portion 52 even when electromagnetic waves propagate to the second portion 52. Therefore, it is possible to suppress adverse effects on the operation of the qubits 30a and 30b.

In the first embodiment and the variations thereof, the first portion 51 of the spacer portion 50 is made of the same material as the base material 41 of the connection substrate 40 and is provided integrally with the connection substrate 40. This inhibits the relative position in the XY direction between the qubit substrates 10a and 10b and the connection substrate 40 from deviating from the appropriate position when the connection substrate 40 is placed on the qubit substrates 10a and 10b by the spacer portion 50. Therefore, the electrostatic capacitance between the pad 17a and the pad 47a and the electrostatic capacitance between the pad 17b and the pad 47b can be stabilized, and the qubit 30a and the qubit 30b can be stably connected. In this case, as illustrated in FIG. 10A and FIG. 10B, the spacer portion 50 formed integrally with the connection substrate 40 is brought into contact with the bottom surfaces 15a and 15b of the recesses 14a and 14b formed in the qubit substrates 10a and 10b. Accordingly, the connection substrate 40 is disposed so as to face the upper surfaces 12a and 12b of the qubit substrates 10a and 10b.

In the first embodiment and the second variation of the first embodiment, as illustrated in FIG. 4 and FIG. 15, the first portion 51 of the spacer portion 50 is in contact with the bottom surfaces 15a and 15b of the recesses 14a and 14b formed in the qubit substrates 10a and 10b. That is, no other film such as a metallic film is provided between the first portion 51 and each of the bottom surfaces 15a and 15b. This inhibits the distance between each of the qubit substrates 10a and 10b and the connection substrate 40 in the Z-axis direction from deviating from the appropriate distance. Therefore, the electrostatic capacitance between the pad 17a and the pad 47a and the electrostatic capacitance between the pad 17b and the pad 47b can be stabilized, and the qubit 30a and the qubit 30b can be stably connected.

In the first variation of the first embodiment, as illustrated in FIG. 14, the spacer portion 50 is provided so that the second portions 52 cover the side surfaces and the lower surfaces of the first portion 51. This further inhibits electromagnetic waves generated by the operation of the qubits 30a and 30b from leaking to the outside through the spacer portion 50.

In the first embodiment and the first variation of the first embodiment, as illustrated in FIG. 4 and FIG. 14, the spacer portion 50 is provided between the connection substrate 40 and both the qubit substrates 10a and 10b. The spacer portion 50 is provided so as to be in contact with the bottom surface 15a (third surface) of the recess 14a formed in the qubit substrate 10a and the bottom surface 15b (fifth surface) of the recess 14b formed in the peripheral portion of the qubit substrate 10b. This inhibits the distance between each of the qubit substrates 10a and 10b and the connection substrate 40 in the Z-axis direction from deviating from the appropriate distance. Since the bottom surface 15a of the recess 14a and the bottom surface 15b of the recess 14b are located in the same plane, it is possible to further inhibit the distance between each of the qubit substrates 10a and 10b and the connection substrate 40 in the Z-axis direction from deviating from the appropriate distance.

In the first embodiment and the variations thereof, the qubit substrate 10a includes the protruding conductive portion 16a located between the qubit 30a and the spacer portion 50 on the upper surface 12a. Similarly, the qubit substrate 10b includes the protruding conductive portion 16b located between the qubit 30b and the spacer portion 50 on the upper surface 12b. By providing the conductive portions 16a and 16b, it is possible to inhibit the electromagnetic waves generated by the operation of the qubits 30a and 30b from leaking to the outside by the conductive portions 16a and 16b. The conductive portions 16a and 16b are not in contact with the connection substrate 40 and are separated from the connection substrate 40. This inhibits the distance between each of the qubit substrates 10a and 10b and the connection substrate 40 in the Z-axis direction from deviating from the appropriate distance.

In the first embodiment and the variations thereof, the depths of the recesses 14a and 14b formed in the qubit substrates 10a and 10b, respectively, are preferably 40 µm or greater and 180 µm or less. In other words, the height between the upper surface 12a of the base material 11a and the bottom surface 15a of the recess 14a and the height between the upper surface 12b of the base material 11a and the bottom surface 15b of the recess 14b are preferably 40 µm or greater and 180 µm or less. As a result, as illustrated in the above simulation results, in the frequency band of 8 GHz ± 0.5 GHz, which is typically used in qubit devices, it is possible to inhibit electromagnetic waves generated by the operation of the qubits 30a and 30b from leaking to the outside. To prevent or reduce leakage of electromagnetic waves, the height between the upper surface 12a and the bottom surface 15a and the height between the upper surface 12b and the bottom surface 15b are preferably 60 µm or greater and 180 µm or less, more preferably 80 µm or greater and 180 µm or less, and still more preferably 100 µm or greater and 130 µm or less.

### Second Embodiment

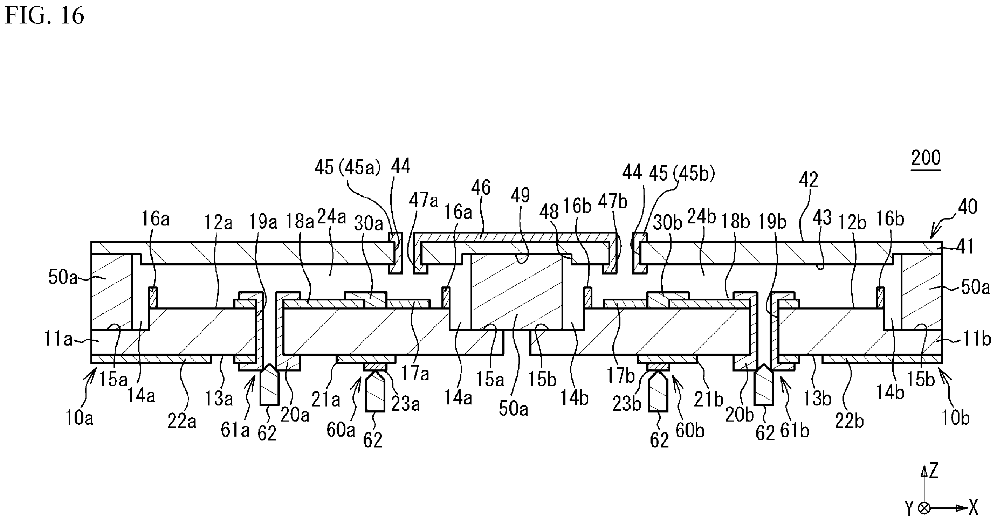

FIG. 16 is a cross-sectional view of a qubit device 200 according to a second embodiment. As illustrated in FIG. 16, in the second embodiment, a spacer portion 50a is provided as a member separate from the connection substrate 40. The spacer portion 50a is formed of a material having conductivity, and is formed of, for example, aluminum, which is a superconducting material. The connection substrate 40 has a recess portion 48 on the lower surface 43. The spacer portion 50a is in contact with the bottom surfaces 15a and 15b of the recesses 14a and 14b formed in the qubit substrates 10a and 10b, and a bottom surface 49 of the recess portion 48 formed in the connection substrate 40. The spacer portion 50a is connected to, for example, the ground as in the first embodiment, but may be a floating conductor. Other configurations are the same as those of the first embodiment, and thus the description thereof will be omitted.

The spacer portion 50a is not limited to being formed of aluminum, and may be formed to contain at least one of the following substances: niobium, vanadium, tantalum, aluminum, titanium, zinc, gallium, zirconium, molybdenum, technetium, cadmium, indium, tin, hafnium, and titanium nitride.

### Method for Assembling and Manufacturing Qubit Substrate and Connection Substrate

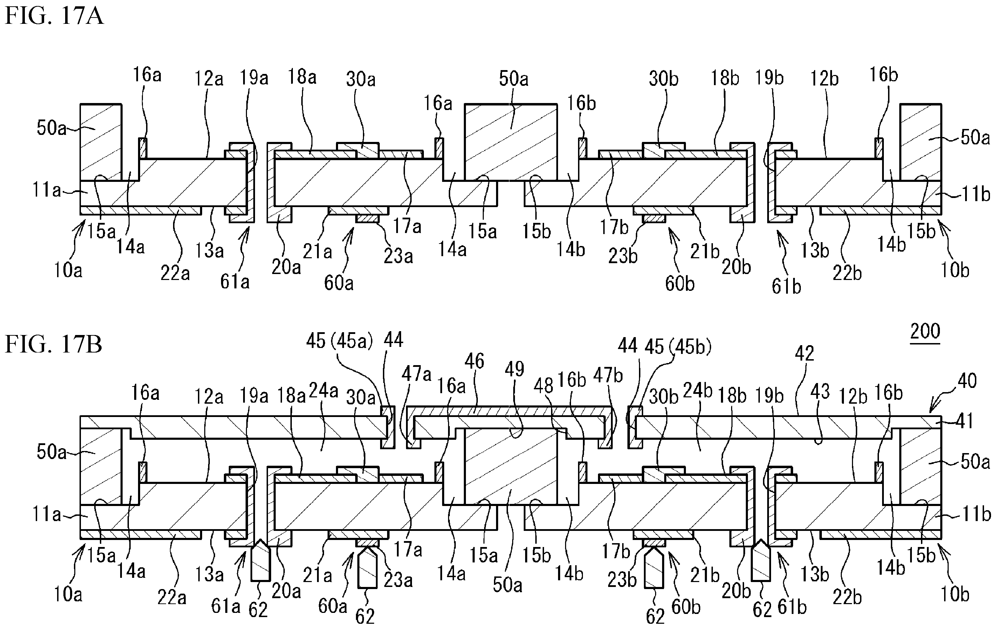

FIG. 17A and FIG. 17B are cross-sectional views illustrating a method of assembling and manufacturing the qubit substrate and the connection substrate in the second embodiment. In FIG. 17A and FIG. 17B, the qubit substrate 10a and the qubit substrate 10b among the plurality of qubit substrates 10 are illustrated and described, but the same applies to other qubit substrates 10.

As illustrated in FIG. 17A, the qubit substrate 10a and the qubit substrate 10b are arranged so that the respective upper surfaces 12a and 12b of the qubit substrates 10a and 10b are located in the same plane. The spacer portion 50a is disposed in contact with the bottom surfaces 15a and 15b of the recesses 14a and 14b formed in the qubit substrates 10a and 10b.

As illustrated in FIG. 17B, the bottom surface 49 of the recess portion 48 provided in the connection substrate 40 is brought into contact with the spacer portion 50a. As a result, the connection substrate 40 is mounted on the qubit substrates 10a and 10b. In the above manner, the assembly of the qubit substrates and the connection substrate is completed, and the qubit device 200 according to the second embodiment is formed.

The spacer portion 50a is disposed so as to be in contact with the bottom surface 49 of the recess portion 48 provided in the connection substrate 40 first. Thereafter, the bottom surfaces 15a and 15b of the recesses 14a and 14b of the qubit substrates 10a and 10b may be brought into contact with the spacer portion 50a. Variation

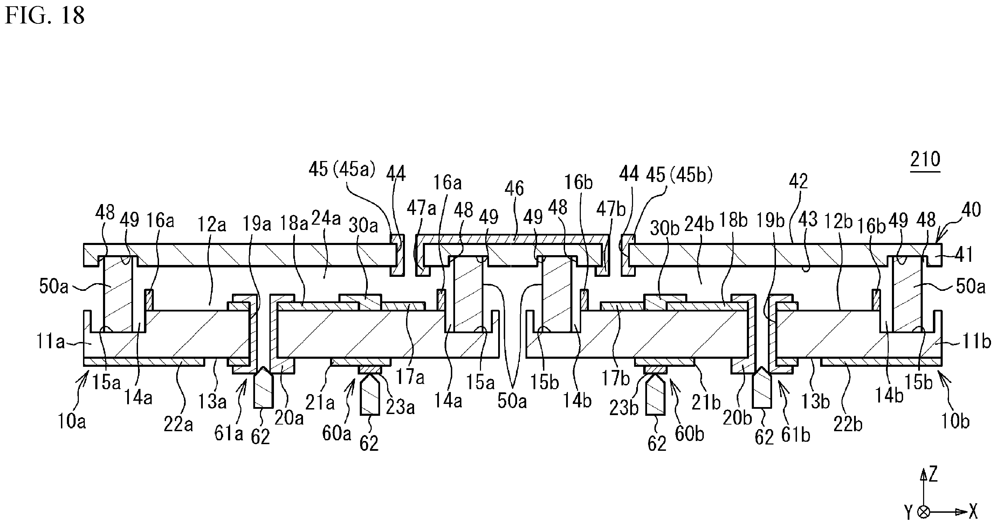

FIG. 18 is a cross-sectional view of a qubit device 210 according to a variation of the second embodiment. As illustrated in FIG. 18, in the variation of the second embodiment, the spacer portion 50a that is in contact with the bottom surface 15a of the recess 14a formed in the qubit substrate 10a and the spacer portion 50a that is in contact with the bottom surface 15b of the recess 14b formed in the qubit substrate 10b are separately provided. The recesses 14a and 14b may be provided inwardly away from the outer edges of the base materials 11a and 11b, respectively. Other configurations are the same as those of the second embodiment, and thus the description thereof will be omitted.

In the second embodiment and the variation thereof, similarly to the first embodiment and the variation thereof, the upper surface 12a (first surface) of the qubit substrate 10a (first qubit substrate) and the upper surface 12b (second surface) of the qubit substrate 10b (second qubit substrate) are located in the same plane. The qubit 30a (first qubit) is formed on the upper surface 12a. The qubit 30b (second qubit) is formed on the upper surface 12b. The connection substrate 40 is disposed so as to face the upper surfaces 12a and 12b by the spacer portion 50a. The spacer portion 50a is located at least between the connection substrate 40 and the qubit substrate 10a, and is provided so as to be in contact with the bottom surface 15a (third surface), which is lower than the upper surface 12a, of the recess 14a provided in the peripheral portion of the qubit substrate 10a. This lengthens the shortest distance of the propagation path of electromagnetic waves between the qubit substrate 10a and the qubit substrate 10b. Therefore, it is possible to prevent or reduce penetration of electromagnetic waves between the qubit substrate 10a and the qubit substrate 10b, and to suppress deterioration of the qubit characteristics.

According to the second embodiment and the variation thereof, as illustrated in FIG. 17A and FIG, 17B, prepared is the qubit substrate 10a that has the qubit 30a formed on the upper surface 12a and has the recess 14a of which the bottom surface 15a is lower than the upper surface 12a in the peripheral portion. Prepared is the qubit substrate 10b having the qubit 30b formed on the upper surface 12b. The connection substrate 40 is disposed so as to face the upper surfaces 12a and 12b located in the same plane by bringing the spacer portion 50a into contact with the bottom surface 15a of the recess 14a. This lengthens the shortest distance of the propagation path of electromagnetic waves between the qubit substrate 10a and the qubit substrate 10b. Therefore, it is possible to prevent or reduce penetration of electromagnetic waves between the qubit substrate 10a and the qubit substrate 10b, and to suppress deterioration of the qubit characteristics.

In the second embodiment and the variation thereof, the spacer portion 50a is formed of a conductive material. This inhibits electromagnetic waves generated by the operation of the qubits 30a and 30b from leaking to the outside through the spacer portion 50a. Therefore, it is possible to prevent or reduce penetration of electromagnetic waves between the qubit substrate 10a and the qubit substrate 10b. In this case, as illustrated in FIG. 17A and FIG. 17B, the spacer portion 50a is brought into contact with the bottom surfaces 15a and 15b of the recesses 14a and 14b formed in the qubit substrates 10a and 10b and the connection substrate 40. This allows the connection substrate 40 to be disposed opposite the upper surfaces 12a and 12b of the qubit substrates 10a and 10b. The spacer portion 50a is preferably formed of a superconducting material, similar to the second portion 52 of the spacer portion 50 in the first embodiment.

In the second embodiment and the variation thereof, the connection substrate 40 has the recess portion 48 on the lower surface 43 (fourth surface). The spacer portion 50a is in contact with the bottom surfaces 15a and 15b of the recesses 14a and 14b formed in the qubit substrate 10a and 10b, and the bottom surface 49 of the recess portion 48 formed in the connection substrate 40. This inhibits the relative position between each of the qubit substrates 10a and 10b and the connection substrate 40 in the XY direction from deviating from the appropriate positions.

Although the exemplary embodiments of the present invention have been illustrated in detail, the present invention is not limited to the above-mentioned embodiments, and other embodiments, variations and modifications may be made without departing from the scope of the present invention.

## Claims

1. A qubit device comprising:
a first qubit substrate (10a) having a first qubit (30a) formed on a first surface (12a);
a second qubit substrate (10b) having a second qubit (30b) formed on a second surface (12b);
a connection substrate (40) disposed to face the first surface and the second surface; and
a spacer portion (50) provided to be located at least between the connection substrate and the first qubit substrate,
wherein the first surface and the second surface are located in a same plane, and
wherein the spacer portion is provided to be in contact with a third surface (15a) that is provided in a peripheral portion of the first qubit substrate and is lower than the first surface.

2. The qubit device according to claim 1,
wherein the first qubit substrate (10a) includes a first pad (17a) that is provided on the first surface (12a) and is connected to the first qubit (30a),
wherein the second qubit substrate (10b) includes a second pad (17b) that is provided on the second surface (12b) and is connected to the second qubit (30b), and
wherein the connection substrate (40) includes a third pad (47a) facing the first pad, a fourth pad (47b) facing the second pad, and a wiring line (46) connecting the third pad and the fourth pad.

3. The qubit device according to claim 1 or 2, wherein the spacer portion (50) includes a first portion (51) formed of a material having an insulating property, and a second portion (52) that is formed of a material having conductivity and is provided on a side surface of the first portion.

4. The qubit device according to claim 3, wherein the first portion (51) is formed of a same material as a base material (41) of the connection substrate (40) and is provided integrally with the connection substrate.

5. The qubit device according to claim 3, wherein the spacer portion (50) is provided so that the first portion (51) is in contact with the third surface (15a).

6. The qubit device according to claim 1 or 2, wherein the spacer portion (50a) is formed of a material having conductivity.

7. The qubit device according to claim 6, wherein the connection substrate (40) has a recess portion (48) on a fourth surface (43) facing the first surface (12a) and the second surface (12b), and the spacer portion (50a) is in contact with a bottom surface (49) of the recess portion.

8. The qubit device according to claim 1 or 2, wherein the spacer portion (50) is provided between the connection substrate (40) and the first qubit substrate (10a) and between the connection substrate (40) and the second qubit substrate (10b), and is provided to be in contact with the third surface (15a) and a fifth surface (15b), which is provided on a peripheral portion of the second qubit substrate and is lower than the second surface (12b).

9. The qubit device according to claim 8, wherein the third surface (15a) and the fifth surface (15b) are located in a same plane.

10. The qubit device according to claim 1 or 2, wherein the first qubit substrate (10a) has a conductive portion (16a) that protrudes on the first surface, the conductive portion being located between the first qubit (30a) and the spacer portion (50), and the conductive portion is separated from the connection substrate (40).

11. The qubit device according to claim 1 or 2, wherein a height between the first surface (12a) and the third surface (15a) is 40 µm or greater and 180 µm or less.

12. A method of manufacturing a qubit device, the method comprising:
preparing a first qubit substrate (10a) having a first surface (12a) on which a first qubit (30a) is formed and a third surface (15a) lower than the first surface in a peripheral portion;
preparing a second qubit substrate (10b) having a second surface (12b) on which a second qubit (30b) is formed; and
disposing a connection substrate (40) so as to face the first surface and the second surface located in a same plane by bringing a spacer portion (50) into contact with the third surface.

13. The method according to claim 12, wherein the disposing of the connection substrate (40) includes disposing the connection substrate so as to face the first surface (12a) and the second surface (12b) by bringing the spacer portion (50) into contact with the third surface (15a), the spacer portion including a first portion (51) and a second portion (52), the first portion being formed of a same insulating material as a base material (41) of the connection substrate and being provided integrally with the connection substrate, the second portion being formed of a material having conductivity and being provided on a side surface of the first portion.

14. The method according to claim 12, wherein the disposing of the connection substrate (40) includes disposing the connection substrate so as to face the first surface (12a) and the second surface (12b) by bringing the spacer portion (50a) formed of a material having conductivity into contact with the connection substrate and the third surface.
